# EUROPÄISCHE PATENTANMELDUNG

(11) **EP 1 980 645 A1**
(43) Veröffentlichungstag der Anmeldung: **15.10.2008**
(21) Anmeldenummer: 08154359.7
(22) Anmeldetag: 11.04.2008
(51) Int. Cl.: C23C 16/02, C23C 16/26, C23C 16/455, C23C 4/12, C23C 4/06, C23C 28/04

(54) **Verfahren zum Aufbringen einer mehrlagigen Beschichtung auf Werkstücke und/oder Werkstoffe**

(30) Priorität: 13.04.2007 DE 102007017891; 04.12.2007 DE 102007058484
(71) Anmelder: Stein, Ralf, 44229 Dortmund (DE); Matthäus, Götz, 44577 Castrop-Rauxe (DE)
(72) Erfinder: Stein, Ralf, 44229 Dortmund (DE); Matthäus, Götz, 44577 Castrop-Rauxel (DE); Nöll, Oliver, 34613 Schwalmstadt (DE)
(74) Vertreter: Michalski Hüttermann & Partner Patentanwälte

(57) **Zusammenfassung**

Die Erfindung betrifft ein Verfahren zum Aufbringen einer mehrlagigen Beschichtung auf Werkstücke und/oder Werkstoffe, aufweisend die folgenden Schritte: Aufbringen einer Stützschicht auf das Werkstück bzw. den Werkstoff durch thermisches Spritzen oder Plasmaspritzen; Aufbringen einer haftvermittelnden Zwischenschicht; sowie Aufbringen einer kohlenstoff- oder siliziumhaltigen Deckschicht durch Plasmaverdampfung (Fig. 3B).

## Beschreibung

Die vorliegende Erfindung betrifft ein Verfahren zum Aufbringen einer mehrlagigen Beschichtung auf Werkstücke und/oder Werkstoffe gemäß dem Oberbegriff des Anspruchs 1.

### Stand der Technik

Um die Standzeiten und die Reibungskoeeffizienten von Werkstücken und Werkstoffen zu verbessern, werden seit längerer Zeit schon Oberflächenbeschichtungen eingesetzt. Hier kommen insbesondere kohlenstoffhaltige Beschichtungen ("diamond like carbon") Beschichtungen zum Einsatz.

Dieser Beschichtungstyp zeichnet sich durch eine große Härte, eine hohe Widerstandsfähigkeit gegen tribologische Belastungen sowie eine hohe Glätte verbunden mit einem niedrigem Reibkoeffizienten im Bereich von µ=0,1 aus.

Dieser Beschichtungstyp eignet sich insbesondere für Stanz-, Schneid-, Bohr- und Schraubwerkzeuge, Zerspanungswerkzeuge, Prothesen, Kugel- oder Wälzlager, Zahnräder, Ritzel, Antriebsketten, Ton- und Antriebseinheiten in magnetischen Aufzeichnungsgeräten, sowie chirurgische und zahnchirurgische Instrumente. Insbesondere eignet er sich für Messer mit wechselbaren Klingen, so z.B. chirugische Messer, und/oder Klingen und/oder Messer für industrielle Anwendungen.

Häufig besteht das zu beschichtende Werkstück bzw. der zu beschichtende Werkstoff aus Metall, insbesondere aus Stahl oder Edelstahl, Aluminium oder Titan und deren Legierungen. Die Oberfläche dieser Metalle ist im Vergleich zu der aufgebrachten Beschichtung relativ weich und leicht plastisch verformbar. Im Gegensatz hierzu ist die genannte Beschichtung zwar überaus hart, aber dafür spröde. Dies führt in manchen Situationen, nämlich z.B. extrem hohen Punktbelastungen, dazu, dass sich des Werkstück bzw. der Werkstoff plastisch verformt und die Beschichtung aufgrund ihrer Sprödheit dieser Verformung nicht folgen kann, sondern bricht oder abplatzt. Man kann sich dieses Verhalten veranschaulichen am Bild einer dünnen Glasscheibe, die auf einer Matratze liegt, und die bei Punktbelastung bricht.

Werkzeuge und Werkstoffe, die mit einer solchen Schicht beschichtet sind, weisen also bei bestimmten Anwendungsbereichen und Belastungsszenarien geringe Lebensdauern und/oder Standzeiten auf.

Aus diesem Grunde werden kohlenstoff- oder siliziumhaltige Beschichtungen häufig mit einer Stützschicht unterlegt, die z.B. aus metallgebundenen Carbiden, Metallen oder Oxiden besteht. Diese Stützschichten weisen nicht die extreme Härte der Decksicht auf, haben aber ausreichend zähharte Eigenschaften, so dass sie bei hohen Punktbelastungen nicht nachgeben, und so einen Bruch oder ein Abplatzen der Deckschicht verhindern.

Ein solcher Schichtaufbau aus carbidhaltiger Stützschicht und kohlenstoffhaltiger Deckschicht ist z.B. aus der DE 10126118 bekannt.

Schraubwerkzeuge mit einer solchen Beschichtung werden z.B. von der Firma Wekador unter dem Markennamen "master.bits carbo.dlc" angeboten. Auch die Firma Metaplas bietet vergleichbare Beschichtungen unter dem Markennamnen "Maxit W-C:H" an.

Eine solche Stützschicht wird häufig durch thermisches spritzen oder Plasmaspritzen von carbid- oder oxidhaltigen Pulvern auf die zu beschichtende Oberfläche aufgebracht.

Die Partikel des Pulvers flachen sich beim Auftreffen auf ein Werkstück zu fladenförmigen Gebilden ab. Da diese fladenförmigen Gebilde Abstände zueinander aufweisen, entstehen beim Auftragen dieser Schicht also Lunker, Poren, Kapillaren und Mikrokavitäten. Erst das Aufbringen von weiteren Partikeln auf eine bereits bestehende Schicht führt dazu, dass die bereits bestehende Schicht weiter verdichtet wird, da die fladenförmigen Gebilde weiter abgeflacht werden und dabei die bestehenden Zwischenräume ausfüllen.

Aus diesem Grunde weisen entsprechend aufgebrachte Schichten immer einen Dichtegradienten auf, bei welchem die jeweilige Oberfläche eine geringere Dichte hat als die darunter liegenden Schichten. Dies führt überdies dazu, dass sehr dünne Schichten nur geringe Dichten und überdies viele Lunker und Mikrokavitäten aufweisen und sich daher als Stützschichten in obigem Sinne nicht eignen. Um eine ausreichend hohe Dichte und damit eine Eignung als Stützschicht zu erzielen, muss die Schicht daher eine bestimmte Mindestdicke aufweisen, also eine Mindestanzahl von Lagen. Diese Mindestdicke macht solche Stützschichten ungeeignet für bestimmte Einsatzzwecke, so z.B. die Beschichtung von Klingen und Stanzen, da die erforderliche Schichtdicke mit der nötigen Schärfe dieser Werkzeuge nicht vereinbar ist.

Ein Ansatz, dieses Problem zu beseitigen, liegt darin, vor dem Auftragen der kohlenstoff- oder siliziumhaltigen Schicht die aufgrund ihrer unzureichenden Dichte nicht geeigneten Schichtlagen der Stützschicht durch schleiftechnische Bearbeitung zu entfernen. Hierdurch wird jedoch der Fertigungsaufwand erheblich erhöht und die Wirtschaftlichkeit des Herstellungsverfahrens beeinträchtigt.

Ein weiteres Problem der aus dem Stand der Technik bekannten Kombinationen aus Stützschicht und kohlenstoff- oder siliziumhaltigen Deckschicht ist, dass beide Schichten nur schlecht aneinander haften. Dies führt bei bestimmten Belastungen u.U. zu einer Delaminierung und damit zu einer Zerstörung der Beschichtung.

### Offenbarung der Erfindung

Aufgabe der vorliegenden Erfindung ist es daher, eine Beschichtung für Werkstücke und/oder Werkstoffe bereitzustellen, die diesen an der Oberfläche eine große Härte, eine hohe Zähigkeit, eine hohe Widerstandsfähigkeit gegen tribologische Belastungen, eine hohe Glätte und einen niedrigen Reibkoeffizient verleiht, und die überdies Widerstandsfähig gegen Punktbelastungen ist.

Weitere Aufgabe der vorliegenden Erfindung ist es, eine Beschichtung für Werkstücke und/oder Werkstoffe bereitzustellen, die Widerstandsfähig gegen Punktbelastungen ist und gleichzeitig geeignete Oberflächeneigenschaften bezüglich der Oberflächenspannung und Beständigkeit bezüglich Farben und Reinigungsmitteln wie Säuren und Laugen besitzt, elektrisch isolierende und wärmeleitende Eigenschaften hat, und/oder Biokompatibilität und antiallergische Eigenschaften besitzt.

Weitere Aufgabe der vorliegenden Erfindung ist es, eine Beschichtung für Schneid-, Span-, Bohr-, Schmiede-, Fräs-, Schraub und Stanzwerkzeuge bereitzustellen, die eine hohe Lebensdauer und/oder Standzeit aufweist.

Weitere Aufgabe der vorliegenden Erfindung ist es, eine Lebensdauer und/oder Standzeit verlängernde Beschichtung bereitzustellen, die sich für Klingen mit einer großen Schärfe eignet.

Weitere Aufgabe der vorliegenden Erfindung ist es, eine Lebensdauer und/oder Standzeit verlängernde Beschichtung bereitzustellen, die eine reduzierte Neigung zur Delaminierung der kohlenstoff- oder siliziumhaltigen Schicht aufweist.

Diese Aufgaben werden mit den Merkmalen des vorliegenden Anspruchs 1 gelöst. Die Unteransprüche geben bevorzugte Ausführungsformen an. Dabei ist zu beachten, dass die genannten Bereichsangaben durchweg einschließlich der jeweiligen Grenzwerte zu verstehen sind.

Demnach ist erfindungsgemäß ein Verfahren zum Aufbringen einer mehrlagigen Beschichtung auf Werkstücke und/oder Werkstoffe, aufweisend die folgenden Schritte:
a) Aufbringen einer Stützschicht auf das Werkstück bzw. den Werkstoff durch thermisches Spritzen oder Plasmaspritzen;
b) Aufbringen einer haftvermittelnden Zwischenschicht; sowie;
c) Aufbringen einer kohlenstoff- oder siliziumhaltigen Deckschicht durch Plasmaverdampfung.

Bei dem thermischen Spritzverfahren handelt es sich bevorzugt um das sogenannte Hochgeschwindigkeitsflammspritzen (HVOF), das weiter unten noch erläutert werden wird.

Besonders bevorzugt handelt es sich bei der Deckschicht um eine kohlenstoffhaltige Schicht; insbesondere um eine Schicht aus einem DLC-Material ("Diamond like Carbon") .

Das Werkstück oder der Werkstoff kann insbesondere aus Keramik, Eisen, Stahl, hochlegiertem Stahl, Nickel, Kobalt und deren Legierungen mit Chrom, Molybdän und Aluminium, Kupfer und Kupferlegierungen, Titan oder Legierungen, die die vorgenannten Materialien aufweisen, bestehen. Des weiteren kann das Werkstück oder der Werkstoff aus Metallen und/oder metallischen Legierungen auf Basis von Zn, Sn, Cu, Fe, Ni, Co, Al, Ti, und den Refraktärmetallen wie Mo, W, Ta etc bestehen. Weiter kommen gesinterte Metallwerkstoffe und Metall-Keramik-Komposite (MMC) und Metall-Polymer-Komposite sowie keramische Werkstoffe aus Oxiden, Karbiden, Boriden und Nitriden in Frage.

Das Verfahren ist besonders bevorzugt dadurch gekennzeichnet, dass die Stützschicht aufgebracht wird, indem ein metallisches Pulver durch thermisches Spritzen (insbesondere Hochgeschwindigkeitsflammspritzen) oder Plasmaspritzen auf das Werkstück bzw. den Werkstoff aufgebracht wird.

Als metallisches Pulver kommt hier insbesondere ein Pulver in Frage, das einen Bestandteil ausgewählt aus der Gruppe enthaltend Aluminiumkarbid (Al₄C₃), Aluminiumnitrid (AlN), Aluminiumoxid (Al₂O₃), Aluminiumtitanoxid (Al₂O₃-TiO₂), Aluminiumzirconoxid (Al₂O₃-ZrO₂), Borkarbid (B₄C), Bornitrid (hexagonal) (BN), Calcium wolframat (CaWO₄), Calcium niobat, Chromborid (CrB, CrB₂), Chromdisilizid (CrSi₂), Chromkarbid-Nickel (Cr₃C₂-Ni), Chromkarbid-Nickel-Kobaldnickelchrom-Nickelaluminium (Cr₃C₂-Ni/CoNiCr/NiAl), Chromkarbid-Nickelchrom (Cr₃C₂-NiCr), Chromkarbid (Cr₂C₃), Chromlegierungen, Chromnitrid (CrN, Cr₂N), Chromoxid (Cr₂O₃), Chromtitanoxid (Cr₂O₃-TiO₂), Chromtitansiliciumoxid (Cr₂O₃-TiO₂-SiO₂), CoNi-CrAlYs (CoNiCrAlTaReY), CoNi-CrAlYs (CoNiCrAlY), Eisenpulver, kupferumhüllt (FeCu), Ferrochromnickelmolybdänsilizium (FeCrNiMoSiC), Kobalt - Nickel - Chrom - Legierung (CoNiCrAlY), Kobalt Aluminium Katalysator Legierungen, Kobalt Katalysator, Kobaltlegierungen, verdüst, Lanthanhexaborid (LaB₆), Lithium/Nickel/Cobalt-Oxid, Lithiumnitrid (Li₃N), Magnesiumdiborid (MgB₂), Magnesiumniobat, Metallcarboxylate, Molybdän Metallpulver (Mo-Mo₂C), Molybdän Metallpulver, gedopt (TZM), Molybdän Metallpulver (Mo), Molybdän-NickelSF Metallpulver (Mo-NiSF), Molybdänborid (MoB, MoB₂), Molybdändioxid (MoO₂), Molybdändisilizid (MoSi₂), Molybdänkarbid (Mo₂C), Ni-CrAlYs (NiCoCrAlY), Ni-CrAlYs (NiCrAlY), Nickel Aluminium Katalysatorlegierungen, Nickel Katalysator, Nickel-Niob (NiNb), Nickelbasis-Hartlot-Legierungen, verdüst, Nickelchrom (NiCr), Nickelchromborsilizium (NiCrBSi), Nickelchromkobald (NiCrCo), Nickelgraphit (NiC), Nickelhydroxid (regulär, sphärisch), Niob Metallpulver (Nb), Niobborid (NbB, NbB₂), Niobdisilizid (NbSi₂), Niobkarbid (NbC), Niobnitrid (NbN), Nioboxid, Niobpentoxid (Nb₂O₅), Siliziumhexaborid (SiB₆), Siliziumkarbid (SiC), Siliziummetallpulver (Si), Siliziumnitrid (Si₃N₄), Tantal Metallpulver (Ta), Tantal Niob Carbid, Tantalborid (TaB, TaB₂), Tantaldisilizid (TaSi₂), Tantalkarbid (TaC), Tantalnitrid (TaN), Tantaloxid, Titancarbonitrid (Ti(C, N)), Titandiborid (TiB₂), Titandisilizid (TiSi₂), Titankarbid (TiC), Titannitrid (TiN), Titanoxid (TiO₂), Vanadiumcarbid (VC), Wolfram Metallpulver WMP (W), Wolfram-Titan-Karbid, Wolframborid (WB, W₂B₅), Wolframdisulfid (WS₂), Wolframkarbid-Chromkarbid-Nickel (WC-CrC-Ni), Wolframkarbid-Kobald-Chrom (WC-Co-Cr), Wolframkarbid-Kobald-NickelSF (WC-Co-NiSF), Wolframkarbid-Nickel (WC-Ni), Wolframkarbid-Nickelmolybdänchromeisenkobald (WC-NiMoCrFeCo), Wolframkarbid (WC), Wolframoxid (WO₃), Wolframschmelzcarbid (W₂C/WC), Wolframsilizid (WSix), Yttriumoxid (Y₂O₃), Zirkoniumdiborid (ZrB₂), Zirkoniumdisilizid (ZrSi₂), Zirkoniumkarbid (ZrC), Zirkoniumnitrid (ZrN), Zirkonyttriumoxid (ZrO₂-Y₂O₃) aufweist.

Bei dem Pulver handelt es sich besonders bevorzugt um ein Pulver aufweisend metallgebundene Karbide. Als metallgebundene Carbide kommen hier insbesondere Wolframcarbid-Kobalt (WC-Co), Chromkarbid-Nickel (Cr₃C₂-Ni), TiC-Fe und deren Mischungen, letztere auch metallisch gebunden mit den Metallen Cu, Fe, Ni und Co, oder deren Legierungen und Superlegierungen mit Chrom, Molybdän, Silizium und Aluminium in Frage. Besonders bevorzugt sind Wolframcarbid-Kobalt (WC-Co), Wolframcarbid-Kobalt-Chrom (WC-CoCr), Chromkarbid-Nickelchrom (Cr₃C₂-NiCr₂₀), Chromkarbid-Nickelchrom-Molybdän-Niob (Cr₃C₂-NiCrMoNb) und Titancarbid-Eisen -Chrom-Molybdän-Aluminium (TiC-FeCrMoAl). In einer anderen Ausgestaltung ist vorgesehen, dass es sich bei dem Pulver um ein Pulver aufweisend Oxide handelt.

Als Oxide kommen hier insbesondere Aluminiumoxid, Titandioxid, Chromoxid, Magnesiumoxid, Zirkonoxid und deren Legierungen und Mischungen in Frage.

Der Anteil der metallgebundenen Karbide bzw. Oxide an der Stützschicht liegt bevorzugt in einem Bereich von 30 Vol. % - 90 Vol. %.

In einer weiteren Ausgestaltung kommen für das Pulver insbesondere Metalle und Legierungen in Frage, dabei insbesondere Metalle und metallische Legierungen auf Basis von Cu, Fe, Ni, Co, Al, Ti, und den Refraktärmetallen wie Mo, W, Ta etc. Insbesondere können hier Fe-, Ni- und Co-Legierungen (M=Fe, Ni, Co) der Typen MCr, MCrB und MCrBSi Legierungen mit Anteilen von Mo, Ti, W, Nb und Kohlenstoff verwendet werden.

Besonders bevorzugt ist vorgesehen, dass die Stützschicht durch Hochgeschwindigkeitsflammspritzen aufgebracht wird. Beim Hochgeschwindigkeitsflammspritzen (HVOF) wird das Spritzpulver mit sehr hoher Geschwindigkeit auf das zu beschichtende Substrat gespritzt. Die Wärme zum Aufschmelzen des Pulvers wird durch die Reaktion von Sauerstoff und Brenngas in der Brennkammer erzeugt. Die Temperaturen, die in der Flamme erreicht werden, betragen bis zu etwa 3000°C. Durch die Reaktion dehnt sich das Gas aus und beschleunigt das Spritzpulver auf eine hohe Geschwindigkeit.

Hierbei ist bevorzugt vorgesehen, dass Partikelgeschwindigkeiten von 400 - 2000 m/s erzielt werden. Auf diese Weise wird das Werkstück bzw. der Werkstoff gleichsam hämmernd beschichtet, das heißt es finden dem Schmieden ähnliche Prozesse statt, die für eine innige Verbindung zwischen dem Werkstück bzw. dem Werkstoff und der Beschichtung sorgen.

Dieses Verfahren eignet sich besonders für die oben erwähnten metallgebundenen Carbide, da diese lediglich Temperaturen bis 3000 °C widerstehen können. Bei Temperaturen darüber werden sie oxidiert, da das Hochgeschwindigkeitsflammspritzen unter atmosphärischen Bedingungen stattfindet.

In einer anderen Ausgestaltung ist bevorzugt vorgesehen, dass die Stützschicht durch Plasmaspritzen aufgebracht wird. Für dieses Verfahren wird in der Regel ein Plasmabrenner verwendet, bei dem eine Anode und Kathode durch einen schmalen Spalt getrennt sind. Durch eine Gleichspannung wird ein Lichtbogen zwischen Anode und Katode erzeugt. Das durch den Plasmabrenner strömende Gas wird durch den Lichtbogen geleitet und hierbei ionisiert. Die Ionisation, bzw. anschließende Dissoziation, erzeugt ein hochaufgeheiztes (bis 20000 K), elektrisch leitendes Gas aus positiven Ionen und Elektronen. In diesem erzeugten Plasmajet wird Pulver eingedüst, das durch die hohe Plasmatemperatur aufgeschmolzen wird. Der Plasmagasstrom reisst die Pulverteilchen mit und schleudert sie mit einer Geschwindigkeit von bis zu 1000 m/s auf das zu beschichtende Werkstück. Die Gasmoleküle kehren bereits nach kürzester Zeit wieder in einen stabilen Zustand zurück, setzen keine Energie mehr frei und so sinkt die Plasmatemperatur bereits nach kurzer Wegstrecke wieder ab. Die Plasmabeschichtung erfolgt in der Regel unter atmosphärischem Druck. Für die Schichtqualität sind insbesondere die kinetische und die thermische Energie des Plasmas von Bedeutung. Verwendete Gase sind Argon, Helium, Wasserstoff, Sauerstoff oder Stickstoff.

Insbesondere wird dabei die Verwendung eines Plasmabrenners bevorzugt, welcher durch eine axiale Pulvereindüsung und einen Mehrkathoden - Aufbau gekennzeichnet ist.

Weiterhin ist bevorzugt vorgesehen, dass das verwendete Pulver einen d₅₀-Wert von ≥ 0,1 und ≤ 15 µm aufweist. Der vorerwähnte d₅₀-Wert bezeichnet den Median der Partikelgrösse des verwendeten Pulvers, d.h. den Wert, bezüglich welchem 50 Gew.% der verwendeten Partikel grösser und 50 % der verwendeten Partikel kleiner sind.

Im Stand der Technik werden für das Plasmaspritzen oder das Hochgeschwindigkeitsflammspritzen Pulver mit Partikelgrößen von 5 - 120 µm verwendet. Der d₅₀-Wert dieser Pulver liegt bei etwa 16 - 60 µm. Erfindungsgemäß ist hingegen die Verwendung von Pulvern mit einem wie oben definierten d₅₀-Wert vorgesehen, dieser liegt in bevorzugten Ausführungsformen bei 12 µm (Partikelgrößen zwischen 5 und 15 µm), 6 µm (Partikelgrößen zwischen 3 und 10 µm) und besonders bevorzugt bei 3 µm (Partikelgrößen zwischen 1 und 5 µm) und besonders bevorzugt bei 1 µm (Partikelgrößen zwischen 0,1 und 3 µm).

Entscheidend ist hier, dass die Verwendung feinerer Partikel erstmals die Ausbildung sehr dünner und gleichzeitig hochdichter Schichten ermöglicht, die damit trotz geringer Dicke als stabile Stützschicht für die nachfolgend aufzutragende Deckschicht fungieren können.

Grundsätzlich führt das Aufbringen von Partikeln auf ein Werkstück oder einen Werkstoff zunächst einmal zur Ausbildung einer Schicht, die Lunker, Poren, Mikrokapillaren und Mikrokavitäten aufweist.

So flachen sich z.B. Partikel mit einem Durchmesser von 50 µm bei den genannten Geschwindigkeiten beim Auftreffen auf ein Werkstück zu fladenförmigen Gebilden mit einer Dicke von etwa 8 µm ab. Da diese fladenförmigen Gebilde Abstände zueinander aufweisen, entstehen beim Auftragen dieser Schicht also Mikrokavitäten mit einer Höhe von etwa 8 µm. Erst das Aufbringen von Partikeln auf eine bereits bestehende Schicht führt dazu, dass die bereits bestehende Schicht weiter verdichtet wird, da die fladenförmigen Gebilde weiter abgeflacht werden und dabei die bestehenden Zwischenräume ausfüllen. Mit größeren Partikeln lässt sich also eine Schicht mit einer ausreichend hohen Dichte an der Oberfläche nicht erzeugen.

Die Verwendung von ultrafeinen Partikeln ermöglicht es hingegen, dass bereits die erste aufgetragene Schicht eine hohe Dichte aufweist, da die beim Auftreffen auf die Oberfläche entstehenden fladenförmigen Gebilde - und die damit entstehenden Lunker und Mikrokavitäten - eine geringere Dicke aufweisen. So flacht sich ein Partikel mit einem Durchmesser von 5 µm beim Auftreffen auf die Oberfläche zu einem fladenförmigen Gebilde mit einer Dicke von etwa 0,5 µm ab. Dabei entstehen also Mikrokavitäten mit einer Höhe von lediglich etwa 0,5 µm. So wird es möglich, Schichten zu erzeugen, die trotz geringer Dicke eine hohe Dichte aufweisen und/oder die auch an ihrer Oberfläche eine ausreichend hohe Dichte aufweisen.

Zu diesem Effekt kommt hinzu, dass sich Partikel des erfindungsgemäß bevorzugten Größenbereichs beim thermischen Spritzen und beim Plasmaspritzen auf sehr viel höhere Geschwindigkeiten beschleunigen lassen und deshalb im Verhältnis zu ihrer Masse mit sehr viel höheren kinetischen Energien auf die Oberfläche des zu beschichtenden Werkstoffs bzw. Werkstücks auftreffen. So lassen sich z.B. Partikel mit einem Durchmesser von 40µm auf 200 m/s, Partikel mit einem Durchmesser von 5µm hingegen auf 1000m/s und Partikel mit einem Durchmesser von 1µm auf 1400m/s beschleunigen. Kleinere Partikel können noch höher beschleunigt werden.

Partikel des erfindungsgemäß bevorzugten Größenbereichs flachen daher beim Auftreffen proportional sehr viel stärker ab als größere Partikel, die weniger stark beschleunigt werden und deshalb verhältnismäßig geringere kinetische Energien aufweisen. Dieses Phänomen trägt ebenfalls zu einer erheblich größeren Dichte sowie weniger und kleinerer Lunker und Mikrokavitäten der erfindungsgemäß hergestellten Schicht bei.

Aus diesem Grunde erübrigt sich bei der erfindungsgemäß hergestellten Stützschicht auch ein Nachschleifen der nicht benutzbaren porösen Schichtbestandteile, wie es bei Verwendung größerer Partikel erforderlich ist.

Ein Vorteil der erfindungsgemäß hergestellten Stützschicht ist insbesondere der, dass hier eine sehr dünnlagige Schicht erzeugt wird, die gleichzeitig eine ausreichende Dichte aufweist, um eine sichere Stützung der aufzubringenden Deckschicht zu gewährleisten, so dass diese vor Bruch und dergleichen geschützt wird. Bislang war dies nur mit erheblich dickeren Stützschichten möglich, was jedoch eine Aufbringung auf bestimmte Werkstücke, wie z.B. Messerklingen, Klingen von Stanzwerkzeugen und dergleichen unmöglich machte. Das erfindungsgemäße Verfahren erlaubt es somit erstmals, eine durch Plasma- oder Hochgeschwindigkeitsflammspritzen aufgebrachte Stützschicht auf kritische Werkstücke wie z.B. Klingen oder Stanzwerkzeuge aufzubringen, bzw. letztere aus erfindungsgemäß beschichteten Werkstücken herzustellen.

Pulver der beanspruchten Größenbereiche waren bislang nicht oder nicht wirtschaftlich herstellbar. Die Urheber der vorliegenden Erfindung haben Pulver dieser Größenbereiche erstmals in großen Mengen hergestellt und damit für die Verwendung beim Plasma- oder Hochgeschwindigkeitsflammspritzen verfügbar gemacht.

Hinzu kommt, dass sich feine und ultrafeine Pulver in den im Stand der Technik bekannten Plasma- und Hochgeschwindigkeitsflammspritzvorrichtungen nicht verwenden lassen. Bei Plasmaspritzvorrichtungen stellt sich insbesondere die Schwierigkeit, dass in diesen Vorrichtungen die Pulver seitlich eindosiert werden. Da ein Plasmastrahl eine relativ hohe Viskosität aufweist, die etwa der von Pflanzenöl entspricht, können von seitwärts herangeführte Pulver dann, wenn Sie eine gewisse Größe unterschreiten, nicht mehr in den Strahl eingemischt werden, sondern prallen ab.

Die Urheber der vorliegenden Erfindung haben dieses Problem durch Entwicklung einer eigens hierfür geeigneten Zudosierungsvorrichtung, die Gegenstand einer gesonderten Patentanmeldung ist, gelöst.

Ein weiters Problem liegt darin, dass die in den im Stand der Technik bekannten Plasma- und Hochgeschwindigkeitsflammspritzvorrichtungen verwendeten Fördereinrichtungen Pulver der beanspruchten Größen nicht mit ausreichend hoher Reproduzierbarkeit fördern können. Auch dieses Problem haben die Urheber der vorliegenden Erfindung haben durch Entwicklung einer eigens hierfür geeigneten Fördereinrichtung gelöst.

Bevorzugt weist das erfindungsgemäß verwendete Pulver eine maximale Partikelgröße von ≤ 20 µm, ≤ 15 µm, ≤ 10 µm, ≤ 5 µm, ≤ 3 µm oder ≤ 1 µm auf. Der karbidische Ausgangswerkstoff weist bevorzugt eine maximale Partikelgröße von ≤ 10 µm auf. Besonders bevorzugt weist er eine Partikelgröße von ≤ 3µm, ≤ 1µm, ≤ 0,5µm, ≤ 0,3µm oder ≤ 0,15 µm auf.

Bei den Pulvertypen kann es sich insbesondere um gemischte Pulver, agglomerierte und gesinterte Pulver, umhüllte Pulver sowie umhüllte Karbide mit Legierungen handeln

Die aufgebrachte Stützschicht weist bevorzugt eine Dicke zwischen 10 µm und 3000 µm, besonders bevorzugt zwischen 30 µm und 200 µm auf.

Die Dicke der Stützschicht ist abhängig von der Größe der verwendeten Partikel, der Dauer des Beschichtungsvorgangs sowie der weiteren Verfahrensparameter. Zwar treffen die Partikel in zufällig verteilter Weise auf der zu beschichtenden Oberfläche auf (sogenanntes Schrotrauschen), aber es kann z.B. davon ausgegangen werden, dass bei erfindungsgemäß verwendeten Partikeln mit einem d₅₀-Wert von 5 µm eine einlagige Schicht eine Dicke von etwa 0,5 µm hat.

Bevorzugt weist die Stützschicht eine Dicke im Bereich von 10 - 1000µm, besonders bevorzugt 20 - 100µm auf.

Dabei werden bevorzugt die folgenden Verfahrenparameter eingehalten:
Hochgeschwindigkeitsflammspritzen:
   • WC-Co 83 17 Pulver agglomeriert gesinter Körnung 3-10µm
   • HVOF Brenner vom Typ CJS von Fa. Thermico
   • Sauerstoff 15 - 52 m²/h
   • Wasserstoff 40 - 200 l/min
   • Kerosin 2 - 14 l/h
   • Pulverzuführung 10 - 60 g/min
   • Pulverzuführungsgas Stickstoff 3 - 15 l/min
   • Beschleunigerdüse D10 / 100 mm
   • Brennkammertyp K5.2
   • Spritzabstand 70 - 250mm
Plasmaspritzen:
   • Aluminiumoxid 99,5 geschmolzen gebrochen Körnung 1 - 5µm
   • Axial Plasma Thermico
   • Argon 60 - 120 1/min
   • Stickstoff 10 - 60 1/min
   • Wasserstoff 10 - 60 1/min
   • Pulverzuführung 10 - 90 g/min
   • Pulverzuführungsgas Argon 2 - 10 1/min
   • Plasmadüse 3/8"
   • Spritzabstand 50 - 200mm

Die erfindungsgemäß erzeugte Stützschicht weist bevorzugt eine Härte von 500 - 2000 HV 0.3, besonders bevorzugt von 800 - 1250 HV 0.3 (gemessen nach Vickers HVO 0.3) auf.

Aufgrund ihres ungünstigen Eigenspannungszustandes und der hohen Härte der Stützschicht haftet die kohlenstoff- oder siliziumhaltige Schicht nur sehr schlecht an ersterer. Letztere haften z.B. wesentlich besser an einer Edelstahloberfläche, da diese sehr viel weicher ist. Aus diesem Grunde ist erfindungsgemäß eine Zwischenschicht vorgesehen, die als Haftvermittler zwischen Stütz- und Deckschicht dienen soll. Eine solche Haftschicht ist im Stand der Technik bislang nicht beschrieben.

Besonders bevorzugt ist vorgesehen, dass die Zwischenschicht Elemente aus der 6. und 7 Nebengruppe aufweist. Bevorzugt werden hier Verbindungen verwendet, die die Elemente Cr, Mo, W, Mn, Mg, Ti und oder Si, und insbesondere Gemische derselben, enthalten. Ebenso können sich die einzelnen Bestandteile gradiert über die Tiefe der Haftschicht verteilen.

Dabei ist besonders bevorzugt vorgesehen, dass die Zwischenschicht mittels Plasmaverdampfung auf die Stützschicht aufgebracht wird.

Diese Haftschicht hat einen neutralen Eigenspannungszustand und wirkt aufgrund ihrer Eigenschaft elastisch und plastisch verformbar zu sein, Eigenspannungsausgleichend. Sie hat ein breiteres unkritisches Parameterfeld der Herstellung, im Vergleich zur kohlenstoff- oder siliziumhaltigen Deckschicht, welche erheblich eingeschränkte Bedingungen an der Oberfläche benötigt.

Bevorzugt kommt für die Auftragung der Zwischen- oder Haftschicht das PECVD-Verfahren (Plasma Enhaned CVD) zum Einsatz. Hierbei handelt es sich um das sogenannte "Plasma Enhanced Chemical Vapour Deposition"-Verfahren; dies ist eine Sonderform der "Chemical Vapor Deposition" (CVD), bei der die Abscheidung von dünnen Schichten durch chemische Reaktion in einer Unterdruckkammer erfolgt; hierbei liegt das Material, mit welchem die Beschichtung ausgeführt werden soll, in der Gas- oder Dampfphase vor.

Zusätzlich wird der Prozess durch ein Plasma unterstützt. Dazu wird zwischen dem zu beschichtenden Substrat und einer Gegenelektrode ein starkes elektrisches Feld angelegt, durch das ein Plasma gezündet wird. Das Plasma bewirkt ein Aufbrechen der Bindungen des Reaktionsgases und zersetzt es in Radikale, die sich auf dem Substrat niederschlagen und dort die chemische Abscheidereaktion bewirken. Dadurch kann eine höhere Abscheiderate bei geringerer Abscheidetemperatur als mit CVD erreicht werden.

Die Dicke der Zwischenschicht beträgt bevorzugt zwischen 20 nm und 2000 nm, bevorzugt zwischen 20 und 100 nm. Sie entspricht also im Extremfall einer Atomlage. Grundsätzlich ist die Dicke der Zwischenschicht sehr schwer zu bestimmen; auf die Gründe hierfür wird später noch eingegangen.

Bevorzugt wird die die Stützschicht vor dem Auftragen der haftvermittelnden Zwischenschicht durch Sputtern aktiviert. Durch diesen Schritt wird die Haftung zwischen der Zwischenschicht und der Stützschicht wesentlich verbessert.

Mit Sputtern ist in diesem Zusammenhang Sputterätzen gemeint. Hierbei werden im Plasma Gasionen beschleunigt, und üben dann durch ihre kinetische Energie einen Ätzangriff auf das zu behandelnde Werkstück aus. Es erfolgt dabei keine chemische Reaktion, dieser Vorgang geschieht auf rein physikalischem Wege.

Bevorzugt werden dabei für das Sputtern die Reaktionsgase Sauerstoff, Wasserstoff und / oder Argon verwendet.

Besonders bevorzugt ist überdies vorgesehen, dass der Schritt des Aufbringens der haftvermittelnden Zwischenschicht und der Schritt des Aufbringens einer kohlenstoff- oder siliziumhaltigen Deckschicht ineinander übergehen.

Wie bereits eingangs erwähnt, wird in dieser Ausgestaltung die Deckschicht ebenfalls durch Plasmaverdampfung aufgebracht. Hierbei wird neben einem inerten Schutzgas bevorzugt ein kohlenstoff- oder siliziumhaltiges Reaktionsgas verwendet, so z.B. Methan (CH₄), Ethen (C₂H₄), Acetylen (C₂H₂) oder Methyl-Trichlor-Silan (CH₃SiCl₃). Auf diese Weise läßt sich z.B. eine kohlenstoffhaltige Deckschicht abscheiden, die häufig diamantähnliche Eigenschaften und Strukturen aufweist und deshalb auch als DLC-Schicht ("diamond like carbon") bezeichnet wird.

Eine Siliciumnitrid-Schicht wird hingegen unter Verwendung der Reaktionsgase Ammoniak und Dichlorsilan erzeugt. Für Siliciumdioxid-Schichten werden die Reaktionsgase Silan und Sauerstoff verwendet. Zur Herstellung von Metall/Silicium-Hybriden (Siliciden) wird als Reaktionsgas z.B. Wolframhexafluorid (WF₆) eingesetzt.

Titannitrid-Schichten zum Härten von Werkzeugen werden aus TDMAT (Tetrakis-Dimethyl-Amido-Titanium) und Stickstoff erzeugt. Siliciumcarbid-Schichten werden aus einem Gemisch aus Wasserstoff und Methyl-Trichlor-Silan (CH₃SiCl₃) abgeschieden.

Erfindungsgemäß ist nun vorgesehen, dass die beiden Schichten im Grenzbereich ineinander übergehen. Dies wird erfindungsgemäß dadurch erreicht, dass die Aufbringungsschritte von Zwischen- und Deckschicht ineinander übergehen.

Hierzu müssen Rampen eingestellt werden, d.h. der Übergang vom Beschichtungsgas für die Zwischenschicht zum Beschichtungsgas für die Deckschicht muss fließend mit einem bestimmten zeitlichen Gradienten eingestellt werden. Dasselbe gilt für die Veränderung der Biaszahl beim Übergang von der Zwischen- zur Deckschicht sowie ggf. für weitere Beschichtungsparameter.

Besagte Rampen können wie folgt aussehen: Nach dem Sputterschritt wird 5 s vor Beginn der Auftragung der Zwischenschicht die Biasspannung V_{Bias} auf die gewünschte Höhe angehoben. Danach wird mit einer extrem kurze Rampe (10 s) das Reaktionsgas für den Haftvermittler eingelassen. Nach Ablauf der Auftragunszeit für den Haftvermittler wird das Acetylen-Ventil über einen Zeitraum von 500 s auf den gewünschten Einlasswert graduell geöffnet. Gleichzeitig schließt sich das Haftvermittlerventil in gleicher Zeit graduell. Anschließend wird die Deckschicht noch über die gewünschte Zeit aufgetragen. Bei kritischen Bauteilen kann das Reaktionsgas für den Haftvermittler mit geringem Minutenvolumen bis zum Schluss des Beschichtungsprozesses mitlaufen. Tabelle 1 gibt dieses Verfahren mit beispielhaften Werten wieder:

**Tabelle 1**

| **Zeit (s)** | **Schritt** | **V_{bias}** | **H₂/O₂ (sccm)** | **TMS/Ti (sccm)** | **C₂H₂ (sccm)** |
|---|---|---|---|---|---|
| -200 | Sputter | 300 | 50/150 | 0 | 0 |
| -5 | Rampe | 300 | 50/150 | 0 | 0 |
| 0 | Zwischenschicht | 350 | 0 | 0 | 0 |
| 10 | | 350 | 0 | 300 | 0 |
| 600 | Rampe | 350 | 0 | 300 | 0 |
| 1100 | Deckschicht | 350 | 0 | 0 | 250 |
| X | Deckschicht | 350 | 0 | 0 | 250 |

Die verwendete Dimension "sccm" steht für Standardkubikzentimeter pro Minute und stellt einen normierten Volumenstrom dar. In der Vakuumpumpentechnik spricht man auch von der Gaslast. Unabhängig von Druck und Temperatur wird mit dieser Norm eine definierte strömende Gasmenge (Teilchenzahl) pro Zeiteinheit erfasst. Ein sccm entspricht einem Gasvolumen von V = 1 cm³ = 1 ml unter Normbedingungen (T = 20 °C und p = 1013,25 hPa).

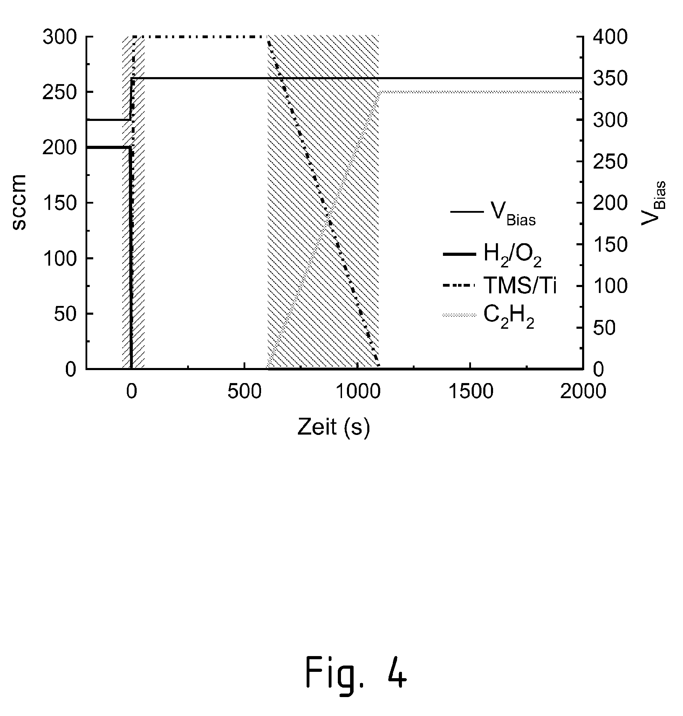

Die beispielhaft dargestellten Rampen sind in Fig. 4 als Diagramm gezeigt. In Abweichung der in Tabelle 1 gezeigten Werte werden bei den verschiedenen Schritten im Wesentlichen folgende Parameterbereiche bevorzugt:

**Tabelle 2**

| **Schritt** | **V_{bias}** | **H₂/O₂ (sccm)** | **Ar (sccm)** | **TMS/Ti (sccm)** | **C₂H₂ (sccm)** | **Druck/ Temp** |
|---|---|---|---|---|---|---|
| Sputter | 300 - 600 | 0-200/0-200 | 0-70 | 0 | 0 | 0,5-2 P 50- 50°C |
| Zwischenschicht | 200 - 500 | 0 | | 100-500 | 0 | 0,1-2 P 50-150°C |
| Deckschicht | 250 - 600 | 0 | | 0-90 | 100-500 | 0,01-0,9 P 50-150°C |

Ebenso kann überdies vorgesehen sein, dass in Bezug auf die für die Haftschicht verwendeten Materialien Rampen gefahren werden.
So kann während der Auftragung vorgesehen sein, dass ein Material Sukzessive durch ein anderes ersetzt wird.

Beim Aufbringen der Deckschicht in der Plasmaverdampfungskammer werden überdies bevorzugt folgende Verfahrensparameter eingehalten:

**Tabelle 3**

| | |
|---|---|
| Temperatur: | 50 - 150 °C, bevorzugt 80 °C |
| Kammervolumen: | 200 - 10.000 l, bevorzugt 900 l |
| Kammerdruck: | 0.0 - 3.0 Pa, bevorzugt 0.0 - 2.0 Pa |
| Biasspannung: | 200 Volt - 600 Volt |
| Dauer: | 1 - 100 Min. |
| Gasstrom: | 50 sccm - 700 sccm |

Die Gaskonzentration in der Kammer ergibt sich jeweils aus dem Gasfluss, dem Volumen der Kammer sowie dem darin herrschenden Druck. Für eine Kammer mit 900 1 Volumen und einem darin herrschenden Druck von 0,0-2,0 Pa ergibt sich z.B. für Acetylen (C₂H₂) bei einem Gasfluss von 100 sccm (0,1175 g per Minute) eine Konzentration von 0,011% des Kammervolumens. Weitere bevorzugt einzustellende Gasflüsse sind z.B. 200 sccm (0,2350 g per Minute C₂H₂ = 0,022 %), 300 sccm (0, 3525 g per Minute C₂H₂ (0, 033 %), 400 sccm (0,4700 g per Minute C₂H₂ = 0,044 %) und 500 sccm (0,5875 g per Minute C₂H₂ = 0,055%).

Eine auf diese Weise unter Verwendung von Acetylen als Reaktionsgas hergestellte DLC-Schicht weist eine Härte von 6000 - 8000 HV und eine Dicke von 0,90 µm bis 5,0 µm auf.

Weiterhin ist erfindungsgemäß eine mehrlagige Beschichtung auf Werkstücken und/oder Werkstoffen, aufweisend die folgenden Schichten:
a) eine Stützschicht bestehend aus durch thermisches Spritzen oder Plasmaspritzen aufgebrachten ultrafeinen Partikeln;
b) eine haftvermittelnde Zwischenschicht; sowie
c) eine kohlenstoff- oder siliziumhaltige Deckschicht.

Die stofflichen Eigenschaften dieser Beschichtung, ihrer Ausgangsmaterialien sowie die Verfahrenseigenschaften und - Parameter für ihre Herstellung sind im Zusammenhang mit den bereits diskutierten Verfahrensansprüchen offenbart und sollen auch in Bezug auf die Beschichtung als solches für offenbart gelten. Dies gilt insbesondere für die durch die Verwendung der ultrafeinen Partikel, bevorzugt bestehend aus metallgebundenen Carbiden oder Oxiden, erzielbare sehr dünne Stützschicht von gleichwohl großer Härte und Dichte, sowie den durch die genannten Rampen erzielbaren Übergang zwischen haftvermittelnder Zwischen- und kohlenstoff- oder siliziumhaltiger Deckschicht.

Ebenso ist eine mehrlagige Beschichtung auf Werkstücken und/oder Werkstoffen vorgesehen, die herstellbar ist mit einem der oben beschriebenen Verfahren.

Weiterhin ist erfindungsgemäß ein Instrument, Werkstück bzw. Werkstoff oder Bauteil vorgesehen, das bzw. der mit einem der oben beschriebenen Verfahren bzw. mit einer mehrlagigen Beschichtung gemäß der obigen Beschreibung beschichtet ist.

Bei diesem Instrument kann es sich z.B. um ein chirurgisches Instrument handeln, wie z.B. ein Skalpell. Ebenso kann es sich bei diesem Instrument um ein Stanzwerkzeug handeln. Weiterhin kann es sich bei dem Instrument z.B. um ein Fleischerei- oder Schlachterei-Schneidwerkzeug handeln

Durch die erfindungsgemäße Beschichtung werden die Standzeiten der genannten Instrumente z.T. erheblich verlängert. So behalten erfindungsgemäß beschichtete Schneidwerkzeuge ihre Schärfe erheblich länger, und zwar auch dann, wenn sie unter widrigen Umständen verwendet werden. Dies gilt insbesondere für Fleischerei- oder Schlachterei-Schneidwerkzeuge, die einerseits weiches Material (Fett, Muskel, Haut, Bindegewebe)schneiden müssen, andererseits jedoch auch hartes Material wie z.B. Knochen und Gefrorenes.

Ein anderes Beispiel sind chirurgische Instrumente, die häufig sterilisiert werden müssen, was bei nicht erfindungsgemäß beschichteten Instrumenten nach kurzer Zeit aufgrund der Sterilisationsbedingungen (Hitze, Feuchtigkeit und Druck) zu starker Korrosion führt. Hierdurch wird einerseits die Eignung des Instruments als solches beeinträchtigt, und anderseits leidet insbesondere die Schärfe der verwendeten Klingen stark.

Weitere erfindungsgemäß zu beschichtende Bauteile sind z.B.:
• Abdichtungen und Bauteile von rotierenden Maschinen wie Pumpen, Gaskompressoren und Turbinen, insbesondere Abdichtungen zwischen rotierendem Bauteil und stehendem Gehäuse
• Bauteile, die Adhäsionsverschleiß und typischem Fretting und Pitting unterliegen.
• Pneumatik- und Hydraulikanlagen, insbesondere das Abdichtungssystem Stange und Zylinder, die Dichtelemente und die Oberflächen von Stangen und Zylindern.
• Motoreneinheiten und Bauteile, insbesondere Kolben mit oder ohne Kolbenringe, Laufbuchse und Zylinderlaufbahn, Ventile und Nockenwellen, Kolben und Pleuel.
• Bauteile von Maschinen, die aggressiven chemischen Prozessen ausgesetzt sind und deren metallische Oberflächen und / oder metallische Substrate chemisch angegriffen und korrodiert werden.
• Bauteile, die hohe Anforderungen an die Biokompatibilität stellen; insbesondere Implantate, Schrauben, Platten, künstliche Gelenke, Stents, biomechanische und mikromechanische Bauteile.
• Operative Bestecke, die grundsätzlich antiallergen sein müssen, wie z.B. Skalpelle, Zangen, Endoskope, Schneidinstrumente, Klammern etc.
• Bauteile, die chemisch beständige Oberflächen gegenüber druckfähige Farben und Reinigungsmittel aufweisen müssen und deren Oberflächen definierte Antihaft- und Flüssigkeitsabweisende und/oder Flüssigkeitsanhaftende Eigenschaften zur definierten Farbdosierung benötigen, wie z.B. Walzen, Zylinder, und Abstreifer von Druckmaschinen.
• Bauteile in stromführenden Maschinen, Rechnern und Anlagen, die eine wärmeabführende aber elektrisch isolierende Oberflächenbeschichtung benötigen, wie z.B. magnetische Speichermedien und Isolierungen von sich bewegenden Stromzuführungen.
• Sich bewegende Medienführungen für Gas, Flüssigkeiten und Gas- oder Flüssigkeitsfluidisierte Feststoffmedien.

Grundsätzlich lassen sich erfindungsgemäß insbesondere Paarungen in Maschinen und Anlagen mit Reibgleit-Verschleiß vorteilhaft beschichten, da diese hohen Drücken und/oder Temperaturen ausgesetzt sind.

### Zeichnungen und Beispiele

Die vorliegende Erfindung wird durch die im Folgenden gezeigten und diskutierten Figuren und Beispiele genauer erläutert. Dabei ist zu beachten, dass die Figuren und Beispiele nur beschreibenden Charakter haben und nicht dazu gedacht sind, die Erfindung in irgendeiner Form einzuschränken.

### Beispiel 1

Ein mit dem beschriebenen Verfahren beschichtetes Schlachtermesser (Schichtaufbau: DLC Deckschicht mit Zwischenschicht auf einer HVOF Beschichtung aus metallgebundenem Wolframkarbid des Typs WC-Co 83 17) wies im Vergleich zu einem herkömmlichen Schlachtermesser mit Kombinationsbeschichtung eine dreifache Standzeit auf.

### Beispiel 2

Ein mit dem beschriebenen Verfahren beschichtetes Industrielles Schneidmesser für Kartoffeln wies im Vergleich zu einem herkömmlichen Schneidmesser mit Kombinationsbeschichtung eine achtfach verlängerte Standzeit auf.

### Beispiel 3

Ein mit dem beschriebenen Verfahren beschichtetes Stanzwerkzeug für die Herstellung von Elektrosteckverbindern für die Automobilindustrie wies im Vergleich zu einem herkömmlichen Stanzwerkzeug eine zweifach verlängerte Standzeit auf.

### Zeichnungen

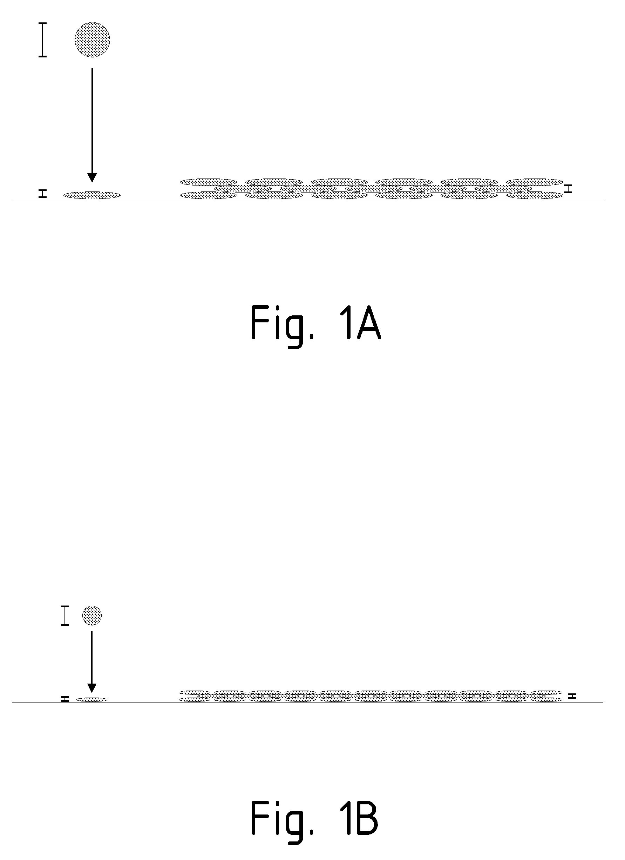

Fig. 1A zeigt ein Modell des Verhaltens von Partikeln mit verhältnismäßig großem Durchmesser, die mittels einem der beschriebenen Verfahren (d.h. thermisches Spritzen oder Plasmaspritzen) auf eine Oberfläche aufgebracht werden.
Die Partikel flachen sich beim Auftreffen auf ein Werkstück zu fladenförmigen Gebilden mit einer bestimmten Dicke ab (siehe Massstab). Da diese fladenförmigen Gebilde Abstände zueinander aufweisen, entstehen beim Auftragen dieser Schicht also Mikrokavitäten mit entsprechenden Höhe.

In Fig. 1B sind diese Phänomene bei Verwendung von nur halb so großen Partikeln gezeigt, um den Vorteil der vorliegenden Erfindung darzustellen. Die sich beim auftreffenden einstellenden fladenförmigen Gebilde weisen eine geringere Dicke auf, und die entstehenden Mikrokavitäten entsprechend eine geringere Höhe. Die Schicht erhält also insgesamt eine höhere Dichte.

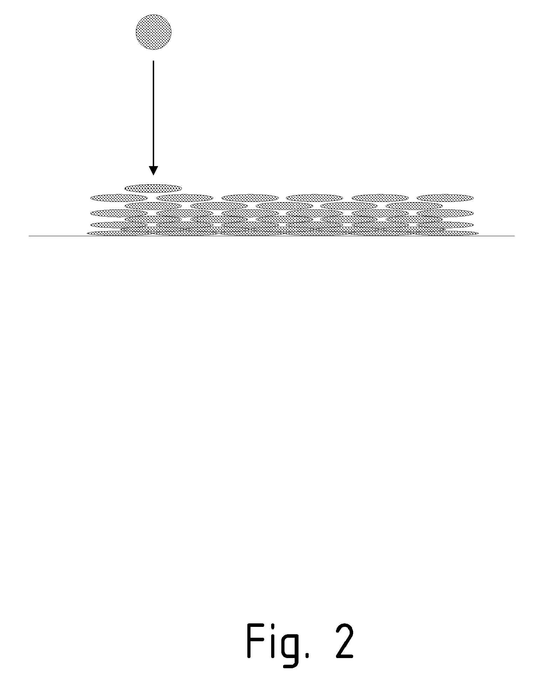

Fig. 2 zeigt im Modell das beschriebene Verhalten beim Aufbringen von mehreren Lagen von Partikeln mit verhältnismässig großem Durchmesser. Dabei führt das Aufbringen von Partikeln auf eine bereits bestehende Schicht führt dazu, dass die bereits bestehende Schicht weiter verdichtet wird, da die fladenförmigen Gebilde weiter abgeflacht werden und dabei die bestehenden Zwischenräume ausfüllen. Mit größeren Partikeln lässt sich also eine Schicht mit einer ausreichend hohen Dichte an der Oberfläche nicht erzeugen.

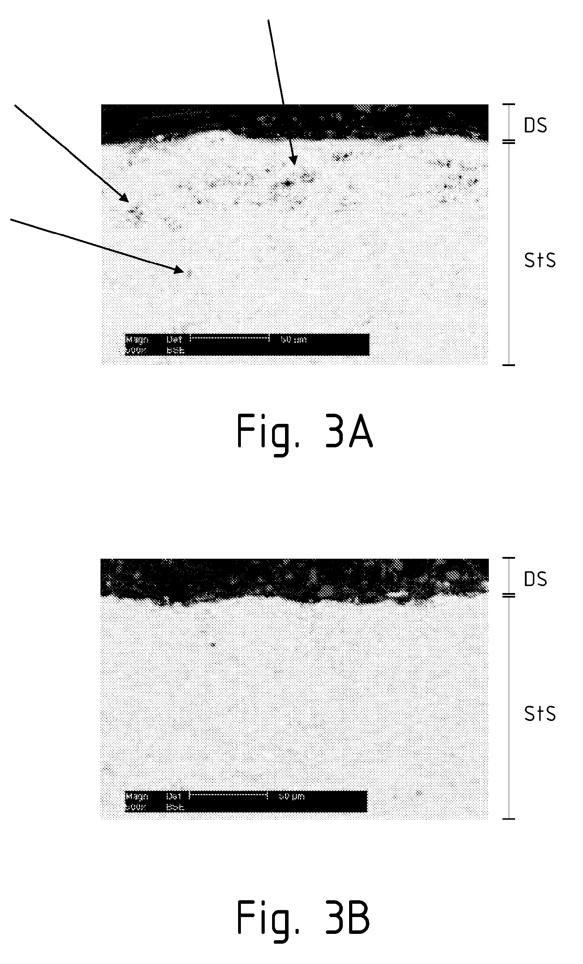

Fig. 3A zeigt die Mikrofotografie eines Schnittes durch eine Stützschicht (StS) sowie eine darauf aufgebrachte Deckschicht (DS), die mit einem Pulver nach dem Stand der Technik (WC-Co 83 17) mittels Hochgeschwindigkeitsflammspritzen auf ein Werkstück aufgetragen wurde. Die Spritzparameter waren wie folgt:
• HVOF Brenner vom Typ CJS von Fa. Thermico
• Sauerstoff 45 m²/h
• Wasserstoff 60 l/min
• Kerosin 18 l/h
• Pulverzuführung 60 g/min
• Pulverzuführungsgas Stickstoff 8 l/min
• Beschleunigerdüse D10 / 140 mm
• Brennkammertyp K4.2
• Spritzabstand 350mm

Der d₅₀-Wert der aufgetragenen Partikel betrug 30 µm. Es ist deutlich erkennbar, dass die oberflächennahen Lagen der Schicht sehr viele Mikrokavitäten, Lunker und dergleichen aufweisen (siehe Pfeile), während die unteren Schichten eine insgesamt höhere Dichte aufweisen. Fig. 3A zeigt also die in Fig. 2 modellhaft dargestellten Phänomene bei Verwendung von verhältnismäßig großen Partikeln.

Fig. 3B zeigt die Mikrofotografie eines Schnittes durch eine erfindungsgemäße Stützschicht (StS) sowie eine darauf aufgebrachte Deckschicht (DS). Die Zwischenschicht ist aufgrund ihrer geringen Dicke nicht erkennbar. Die Stützschicht besteht aus WC-Co 83 17 in ultrafeiner Pulverung und wurde ähnlich wie die in Fig. 3A gezeigte Stützschicht aufgetragen.

Die Spritzparameter waren wie folgt:
• HVOF Brenner vom Typ CJS von Fa. Thermico
• Sauerstoff 45 m²/h
• Wasserstoff 60 l/min
• Kerosin 8 l/h
• Pulverzuführung 40 g/min
• Pulverzuführungsgas Stickstoff 8 l/min
• Beschleunigerdüse D10 / 100 mm
• Brennkammertyp K5.2
• Spritzabstand 120mm

Der d-Wert der aufgetragenen Partikel betrug 6 µm. Es ist deutlich erkennbar, dass die Schicht über ihre gesamte Tiefe eine gleichmäßig hohe Dichte aufweist, und dass insbesondere die oberflächennahen Lagen der Schicht kaum Mikrokavitäten, Lunker und dergleichen aufweisen. Auch ist zu erkennen, dass die Oberfläche der Beschichtung sehr viel glatter und genauer definiert ist als die der in Fig. 3A gezeigten Stützschicht. Die erfindungsgemäß aufgebrachte Stützschicht muss daher in der Regel vor Auftrag der Zwischen- und der Deckschicht anders als die Stützschicht in Fig. 3 A nicht mehr geschliffen werden.

Fig. 4 zeigt ein Zeitdiagramm des Verlaufs der in Tabelle 1 beschriebenen Rampen. Die schraffiert unterlegten Bereiche zeigen dabei die Rampen an.

Die Figs. 5 - 7 zeigen die Ergebnisse der physikalischen Analyse von drei Edelstahl-Werkstücken, von denen eines mit einer Titannitrid-Beschichtung versehen ist ("TiN") sowie zwei weitere mit erfindungsgemäßen Beschichtungen ("M44", Schichtdicke 0,81 µm, "M59", Schichtdicke 0,84 µm, Schichtaufbau: DLC Deckschicht mit Zwischenschicht auf einer HVOF-Beschichtung aus metallgebundenem Wolframkarbid des Typs WC-Co 83 17).

Titanitrid gilt im Stand der Technik als eine der härtesten und widerstandsfähgsten Beschichtungen für Schneid-, Fräs- und Stanzwerkzeuge.

Die Reibungs- und Verschleißprüfung wurde nach SOP 4CP1 (Stift-Scheibe-Tribologie) mit dem Messgerät Messgerät: CSEM Tribometer Pin-Disc durchgeführt.

### Dabei wurden folgende Verfahrensparameter eingehalten:

### Beanspruchunqskollektiv:

■ Gegenkörper: WC-Co-Kugel, Durchmesser 6 mm
■ Schmierstoff: keiner
■ Normalkraft FN: 1 N
■ Drehzahl: 500 min⁻¹
■ Gleitgeschwindigkeit v: 52,4 mm/s
■ Reibspurdurchmesser D: 2 mm

### Randbedinqunqen:

Umgebungstemperatur: 23°C +/- 1K
rel. Luftfeuchtigkeit: 50% +/- 6%

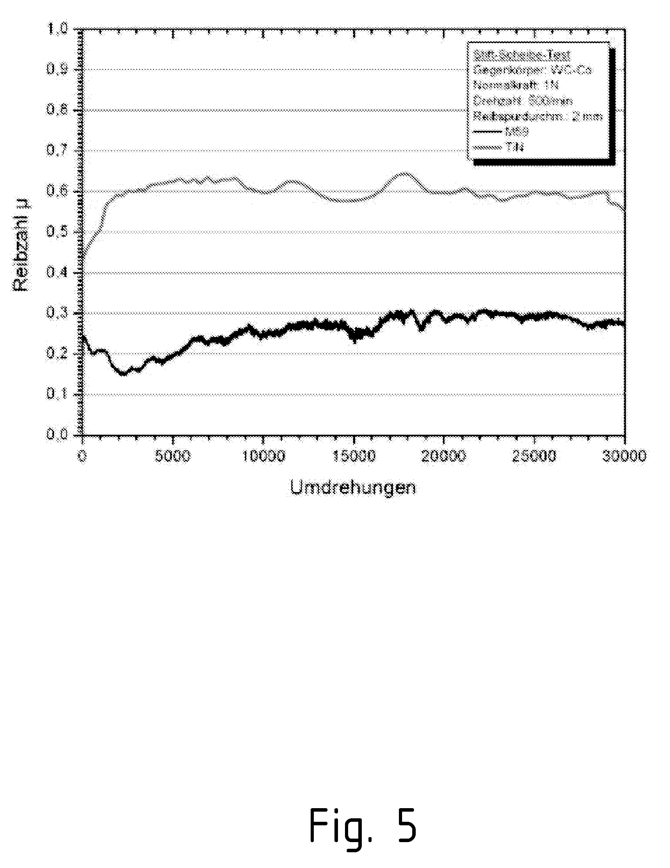

Fig. 5 zeigt die Ergebnisse der Ermittlung der Reibzahl p. Es ist klar erkennbar, dass die erfindungsgemäße Beschichtung mit einer mittleren Reibzahl µ von etwa 0.3 wesentliche Vorteile gegenüber der TiN-Beschichtung aufweist, deren mittlere Reibzahl fast durchweg doppelt so hoch ist.

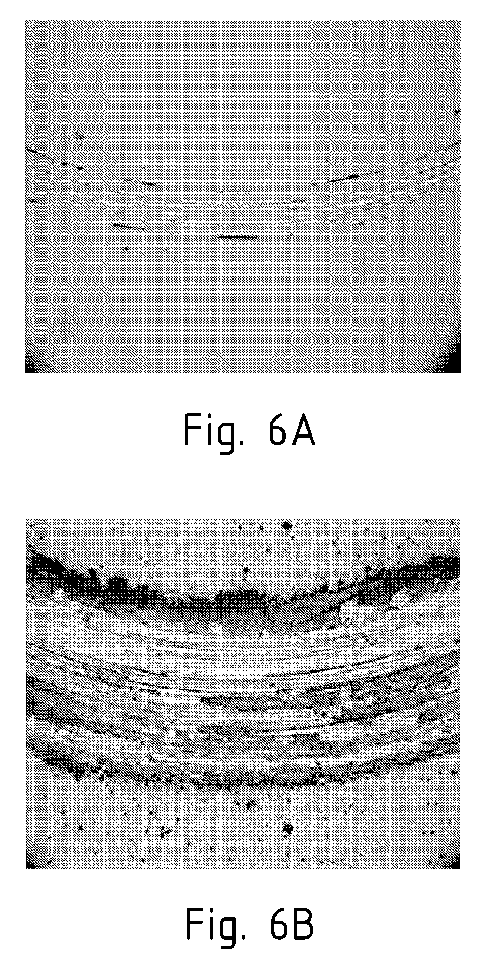

Fig. 6 zeigt die Lichtmikroskopische Dokumentation (Vergrößerung: 100x) des Verschleißes in der Reibspur nach 30000 Umdrehungen bei der erfindungsgemäßen Beschichtung M59 (Fig. 6A) sowie der TiN-Beschichtung (Fig. 6B). Es ist hier klar erkennbar, dass die erfindungsgemäße Beschichtung einen wesentlich geringeren Verschleiß zeigt als die TiN-Beschichtung.

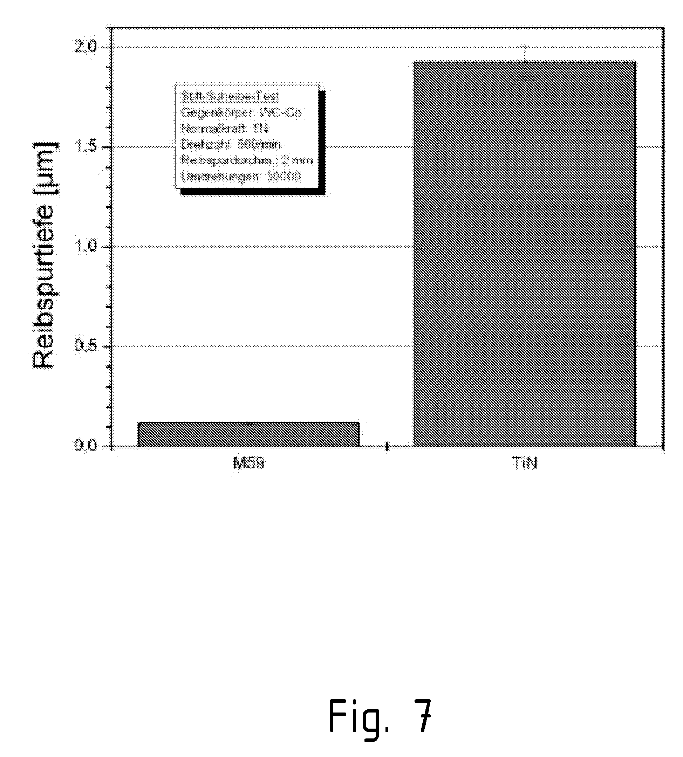

Fig. 7 zeigt die Ergebnisse der Profilometrischen Auswertung der Reibspurtiefe nach 30000 Umdrehungen. Auch hier ist klar erkennbar, dass die erfindungsgemäße Beschichtung einen wesentlich geringeren Verschleiß zeigt als die TiN-Beschichtung.

## Patentansprüche

1. Verfahren zum Aufbringen einer mehrlagigen Beschichtung auf Werkstücke und/oder Werkstoffe, aufweisend die folgenden Schritte:
a) Aufbringen einer Stützschicht auf das Werkstück bzw. den Werkstoff durch thermisches Spritzen oder Plasmaspritzen;
b) Aufbringen einer haftvermittelnden Zwischenschicht; sowie
c) Aufbringen einer kohlenstoff- oder siliziumhaltigen Deckschicht durch Plasmaverdampfung.

2. Verfahren gemäß Anspruch 1, **dadurch gekennzeichnet, dass** die Stützschicht aufgebracht wird, indem ein metallisches Pulver durch thermisches Spritzen oder Plasmaspritzen auf das Werkstück bzw. den Werkstoff aufgebracht wird.

3. Verfahren gemäß Anspruch 2, **dadurch gekennzeichnet, dass** es sich bei dem Pulver um ein Pulver aufweisend metallgebundene Karbide handelt.

4. Verfahren gemäß Anspruch 2, **dadurch gekennzeichnet, dass** es sich bei dem Pulver um ein Pulver aufweisend Oxide handelt.

5. Verfahren gemäß Anspruch 2, **dadurch gekennzeichnet, dass** es sich bei dem Pulver um ein Pulver aufweisende Metalllegierung handelt.

6. Verfahren gemäß einem der vorhergehenden Ansprüche, **dadurch gekennzeichnet, dass** die Stützschicht durch Hochgeschwindigkeitsflammspritzen aufgebracht wird.

7. Verfahren gemäß einem der Ansprüche 1 - 5, **dadurch gekennzeichnet, dass** die Stützschicht durch Plasmaspritzen aufgebracht wird.

8. Verfahren gemäß einem der vorhergehenden Ansprüche, **dadurch gekennzeichnet, dass** das verwendete Pulver einen d₅₀-Wert von ≥ 1 und ≤ 15 µm aufweist.

9. Verfahren gemäß einem der vorhergehenden Ansprüche, **dadurch gekennzeichnet, dass** die aufgebrachte Stützschicht eine Dicke zwischen 10 µm und 3000 µm, bevorzugt zwischen 30 µm und 200 µm aufweist.

10. Verfahren gemäß einem der vorhergehenden Ansprüche, **dadurch gekennzeichnet, dass** die Zwischenschicht Elemente aus der 6. und 7 Nebengruppe aufweist.

11. Verfahren gemäß einem der vorhergehenden Ansprüche, **dadurch gekennzeichnet, dass** die Zwischenschicht mittels Plasmaverdampfung auf die Stützschicht aufgebracht wird.

12. Verfahren gemäß einem der vorhergehenden Ansprüche, **dadurch gekennzeichnet, dass** die Stützschicht vor dem Auftragen der haftvermittelnden Zwischenschicht durch Sputtern aktiviert wird.

13. Verfahren gemäß einem der vorhergehenden Ansprüche, **dadurch gekennzeichnet, dass** der Schritt des Aufbringens der haftvermittelnden Zwischenschicht und der Schritt des Aufbringens einer kohlenstoff- oder siliziumhaltigen Deckschicht ineinander übergehen.

14. Mehrlagige Beschichtung auf Werkstücken und/oder Werkstoffen, aufweisend die folgenden Schichten:
a) eine Stützschicht bestehend aus durch thermisches Spritzen oder Plasmaspritzen aufgebrachten ultrafeinen Partikeln;
b) eine haftvermittelnde Zwischenschicht; sowie
c) eine kohlenstoff- oder siliziumhaltige Deckschicht.

15. Mehrlagige Beschichtung auf Werkstücken und/oder Werkstoffen, herstellbar mit einem Verfahren gemäß einem der Ansprüche 1 - 13.

16. Instrument, Werkstück bzw. Werkstoff oder Bauteil, das bzw. der mit einem Verfahren gemäß einem der Ansprüche 1 - 13 bzw. mit einer mehrlagigen Beschichtung gemäß einem der Ansprüche 14 - 15 beschichtet ist.
